Europäisches Patentamt

European Patent Office

Office européen des brevets

(19)

(11) Publication number: **0 276 572 B1**

# EUROPEAN PATENT SPECIFICATION

(12)

(45) Date of publication of patent specification: **22.04.92**  (51) Int. Cl.⁵: **G05F 3/24**

(21) Application number: **87311418.5**

(22) Date of filing: **23.12.87**

(54) **Intermediate potential generating circuit.**

(30) Priority: **14.01.87 JP 5108/87**

(43) Date of publication of application:
**03.08.88 Bulletin 88/31**

(45) Publication of the grant of the patent:
**22.04.92 Bulletin 92/17**

(84) Designated Contracting States:
**DE FR GB**

(56) References cited:
**EP-A- 0 205 104**

**PATENT ABSTRACTS OF JAPAN, vol. 9, no. 9
(P-327)[1732], 16th January 1985; & JP-A-59
157 727**

(73) Proprietor: **KABUSHIKI KAISHA TOSHIBA
72, Horikawa-cho Saiwai-ku
Kawasaki-shi Kanagawa-ken 210(JP)**

(72) Inventor: **Sawada, Kazuhiro c/o Patent Division
Toshiba Corporation Principal Office
1-1, Shibaura 1-chome Minato-ku Tokyo(JP)**
Inventor: **Sakurai, Takayasu c/o Patent Division
Toshiba Corporation Principal Office
1-1, Shibaura 1-chome Minato-ku Tokyo(JP)**

(74) Representative: **Freed, Arthur Woolf et al
MARKS & CLERK 57-60 Lincoln's Inn Fields
London WC2A 3LS(GB)**

## Description

This invention relates to an intermediate potential generating circuit, formed in a semiconductor integrated circuit, which produces an intermediate potential from the power source voltage applied to the device.

As the scale of semiconductor integrated circuit devices has become larger in recent years, so intermediate potential generating circuits with large current driving capabilities but small power consumption have come to be required.

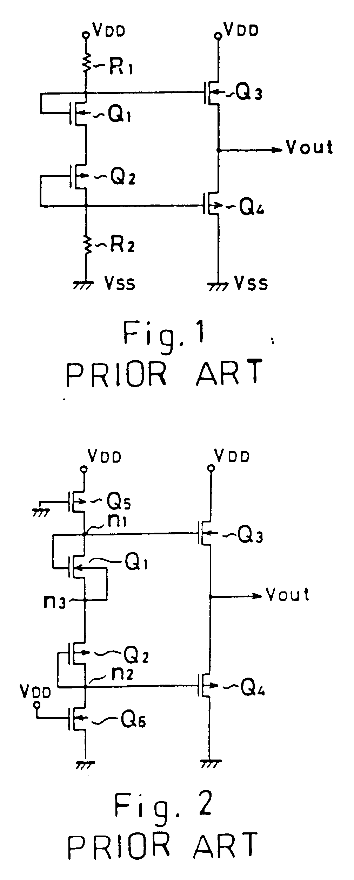

Thus, an intermediate potential generating circuit such as that shown in Figure 1 has been conceived. This related art circuit is the subject of the pre-characterizing portion of Claim 1 below, and is described in the Specification of Japanese Application (Showa) 60-125670, equivalent to EP-A-0205104.

The construction of the intermediate potential generating circuit shown in Figure 1 is as follows. First, two types of intermediate potential are generated by high resistance elements R1 and R2, N-channel type MOS transistor Q1 and P-channel type MOS transistor Q2. These two types of intermediate potential are respectively supplied to the gates of N-channel type MOS transistor Q3 and P-channel type MOS transistor Q4. Transistors Q3 and Q4 have large current drive capabilities and are connected in series between the power sources $V_{DD}$ and $V_{SS}$. Then, an intermediate potential is obtained from the node between transistors Q3 and Q4.

Here, if the threshold voltages of N-channel type MOS transistors Q1 and Q3 are taken as $V_{tn1}$ and $V_{tn3}$ and the threshold voltages of P-channel type MOS transistors Q2 and Q4 are taken as $V_{tp2}$ and $V_{tp4}$, the relationship

$$V_{tn1} + | V_{tp2} | < V_{tn3} + | V_{tp4} |$$

must be satisfied in order to prevent a through current flowing between power source $V_{DD}$ and ground power source $V_{SS}$. However, it is difficult to achieve the above kind of threshold value relationship without increasing the complexity of the production processes.

In order to solve this problem, an intermediate potential generating circuit such as shown in Figure 2 has been conceived. This circuit is described in the Specification of Japanese Patent Publication (Showa) 63-12010, published after the filing date of the present Application. (The circuit is similar to that of Figure 8 of EP-A-0205104, referred to above). In this intermediate potential generating circuit, the back gate of N-channel type MOS transistor Q1 is connected to the node n3 between transistor Q1 and Q2. By doing this, since the threshold voltage of transistor Q1 is lowered by the substrate bias effect, it becomes possible easily to satisfy the threshold value relationship given without increasing the difficulty of the production processes. Moreover, in this Figure , the case of high resistance elements R1 and R2 being replaced by P-channel type MOS transistor Q5 and N-channel type MOS transistor Q6 is shown. In this arrangement, the channel lengths of transistors Q5 and Q6 are made longer than normal and their channel widths are made narrower than normal.

In this way, by using the constructions shown in Figures 1 and 2, intermediate potential generating circuits can be obtained with high current driving capability but low power consumption. However, their outputs, that is to say their intermediate potentials, are greatly influenced by the fluctuation of power source $V_{DD}$, as shown in Figure 3.

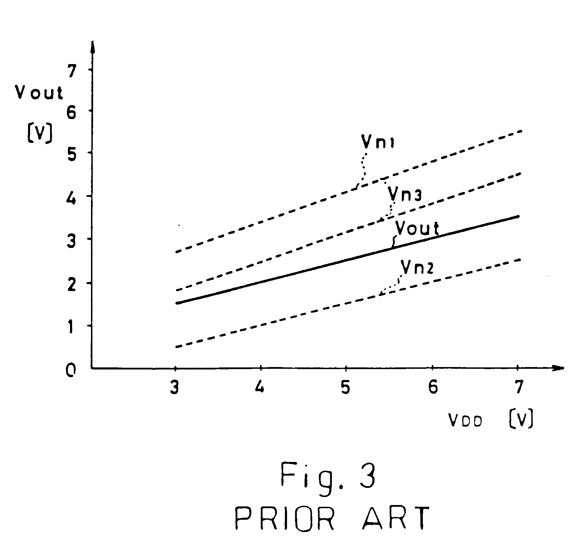

In Figure 3, $V_{n1}$ is the potential of node n1 to which the gate transitor Q3 is connected, $V_{n2}$ is the potential of node $_{n2}$ to which the gate of transistor Q4 is connected, $V_{n3}$ is the potential of node n3 between transistors Q1 and Q2, and $V_{out}$ is the potential of the node between transistors Q3 and Q4, that is to say the output potential.

As can be seen from this Figure, if power source $V_{DD}$ varies from 3[V] to 7[V], the output potential $V_{out}$ which is set at 1.5[V] when power source $V_{DD}$ is 3[3], varies from 1.5[V] according to the variation of power source $V_{DD}$.

An intermediate potential is normally used as the plate voltage for memory cells constructed of capacitors in order to prevent insulation breakdown. However, in cases such as in Figure 3 where the output of the intermediate potential generating circuit depends largely on the fluctuation of power source $V_{DD}$, there are times when the cell data can be destroyed by this fluctuation. This is caused by the fact that when, for example, the potential of power source $V_{DD}$ is greatly reduced by noise or the like, the potential of the N-type diffusion layer which forms the memory node of the capacitor also reduces due to coupling, and by this means the PN junction between the N-type diffusion layer and the P-type diffusion layer is caused to generate a forward bias.

An object of this invention is to provide an intermediate potential generating circuit which can obtain a stable output which does not depend on the fluctuation of the power source potential and, moreover, is preferably of low power consumption and preferably has a large current driving capacity. This is in contrast to convetional intermediate potential generating circuits in which the output potential is greatly influenced by fluctuation of the power source potential.

This invention provides an intermediate potential generating circuit as defined in Claim 1 below.

It is characterized by a constant-voltage means connected between the other end of the second transistor and the second potential supply source for causing a specified voltage drop between the ends of the constant voltage means (in the terminology of Claim 1).

In an intermediate potential generating circuit constructed in accordance with an embodiment of the present invention two types of intermediate potential with small current driving capabilities are generated by; the load element, the first and second transistors and the constant-voltage means. These two types of intermediate potential are respectively supplied to the gates of the third and fourth transistors which have large current capabilities and are connected in series between the first potential supply source and the second potential supply source. In this case, by using the constant-voltage element, even if the potential of the first or second potential supply source fluctuates, the fluctuation of the potentials supplied respectively to the gate of the third and fourth transistors can be controlled. Consequently, it is possible to generate a stable intermediate potential which does not depend on the fluctuation of the power source.

Embodiments of this invention will now be described by way of example only and with refernece to the accompanying drawings, in which :

Figures 1 and 2 are each circuit construction drawings to explain conventional intermediate potential generating circuits,

Figure 3 is a graph showing the variation of the output potential in a conventional intermediate potential generating circuit,

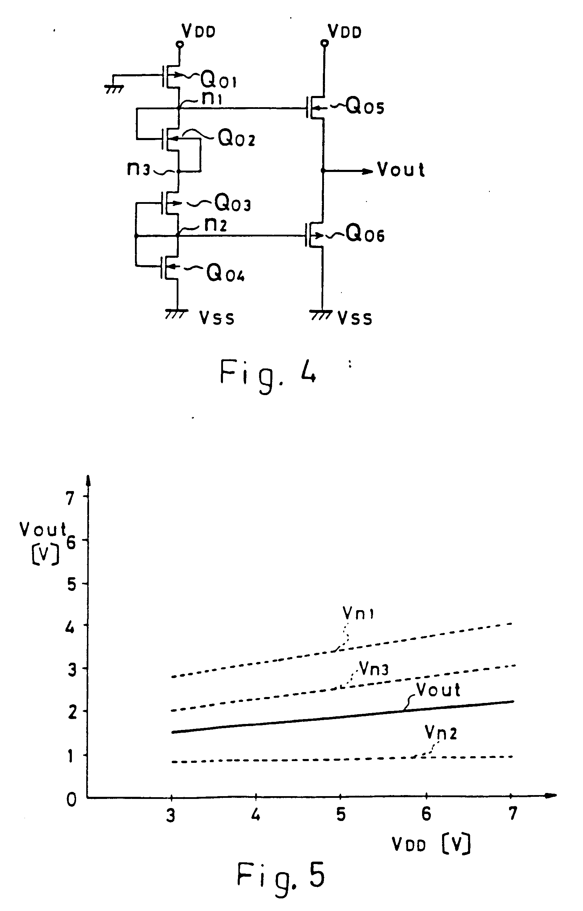

Figure 4 is a circuit diagram of an intermediate potential generating circuit which forms an embodiment of the present invention,

Figure 5 is a graph showing the variation of the output potential of the intermediate potential generating circuit of Figure 4,

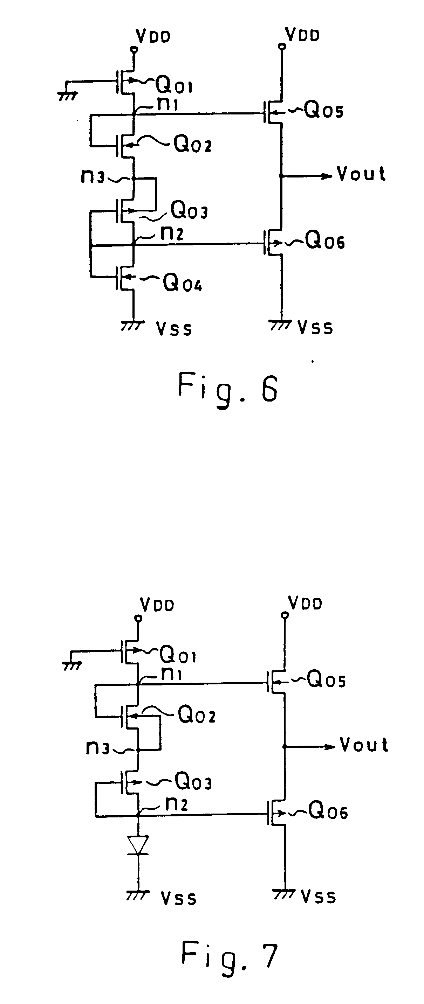

Figure 6 is a circuit diagram of an intermediate potential generating circuit which forms a second embodiment of the present invention,

Figure 7 is a circuit construction drawing related to a further embodiment of this invention.

An embodiment of the present invention which uses a semiconductor construction with a P-type well region formed in an N-type semiconductor substrate will now be explained, with reference to the accompanying drawings.

Figure 4 shows an intermediate potential generating circuit in accordance with a first embodiment of this invention. P-channel MOS transistor Q01, N-channel MOS transistor Q02, P-channel MOS transistor Q03 and N-channel MOS transistors Q04, each having a small current driving capacity, are connected in series between power source $V_{DD}$ and ground power source $V_{SS}$.

P-channel MOS transisstor Q01 acts as a load, since its channel length is set long and its channel width narrow; also its gate is connected to earth power source $V_{SS}$ so that it is always set in the ON state. Moreover, node n1 between transistor Q02 and transistor Q01 is connected to the gate of transistor Q02, and the back gate of transistor Q02 is connected to node n3 between transistors Q02 and transistor Q03. The gate of transistors Q03 and Q04 are interconnected and connected to node n2 which is at the series connection junction of the two transistors. Consequently, transistor Q04 operates to maintain the potential of node n2 constant, by acting in the same way as a diode.

The gate of an N-channel type MOS transistor Q05, which transistor has one terminal connected to the $V_{DD}$ power source, is connected to node n1. The gate of a P-channel type MOS transistors Q06, which transistor is inserted between transistor Q05 and the ground power source $V_{SS}$, is connected to node n2. Thus, the potential of the node between transistors Q05 and Q06 becomes the output potential $V_{out}$ of this intermediate potential generating circuit.

In this kind of intermediate potential generating circuit, by setting each of the channel widths of transistors Q05 and Q06 to be wider than the channel width used in transistors Q01, Q02, Q03 and Q04, transistors Q05 and Q06 will have large current driving capacities.

Moreover, if the threshold voltage of N-channel type MOS transistor Q02 is taken as $V_{tn2}$, the threshold voltage of P-channel type MOS transistors Q03 is taken as $V_{tp3}$, the threshold voltage of N-channel type MOS transistor Q05 is taken as $V_{tn5}$, and the threshold voltage of P-channel type MOS transistos Q06 is taken as $V_{tp6}$, the relationship

$$V_{tn2} + | V_{tp3} | < V_{tn5} + | V_{tp6} |$$

is established between these threshold voltages. Since, if this kind of relationship is established, transistors Q05 and Q06 will not be ON at the same time, the flow of a through current from power source $V_{DD}$ to ground power source $V_{SS}$ can be prevented and production of low power consumption becomes possible.

As mentioned above, even if power source $V_{DD}$ fluctuates, the potential of node n2 is an almost constant value. That is to say, it is maintained at almost the threshold voltage $V_{tn4}$ of transistor Q04. Consequently, for example, the potential rise of node n1 which accompanies the potential rise of power source $V_{DD}$ is controlled. As a result, output potential $V_{out}$ becomes a stable value, as shown in Figure 5, and does not depend on the fluctuation of power source $V_{DD}$.

Figure 5 shows the fluctuation of potentials $V_{n1}$, $V_{n2}$ and $V_{n3}$ at nodes n1, n2 and n3 and output potential $V_{out}$ when power source $V_{DD}$ varies from 3[V] to 7[V]. Even though power source $V_{DD}$ fluctuates from 3[V] to 7[V], the output potential $V_{out}$, which is set at 1.5[V] when power source $V_{DD}$ is 3[V], only increases to about 2.2[V]. The increase which would be 130% or more in a conventional circuit can be controlled to an increase of 50% or less.

Consequently, if an intermediate potential generating circuit constructed in this way is used for the plate voltage supply of memory cells, the destruction of the memory cell data as mentioned above can be prevented.

In the above described circuit, the threshold voltage of transistor Q02 is reduced by connecting the back gate of transistor Q02 to node n3 between transistor Q02 and transistor Q03. However, since it is only important to satisfy the relationship

$$V_{tn2} + |V_{tp3}| < V_{tn5} + |V_{tp6}|$$

it may also be satisfied, without using this kind of substrate bias effect, by setting the degree of impurity of the channel regions or by setting the channel legnths of transistors Q02, Q03, Q04 and Q05.

As shown in Figure 6, it is also possible to satify this kind of threshold value relationship by using a construction in which an N-type well region is formed in a P-type semiconductor substrate, even though the back gate of P-channel type MOS transistor Q03 is connected to node n3 at the point of series connection of transistors Q02 and Q03.

As shown in Figure 7, although transistor Q04 is designated to act as a constant-voltage element in the above described embodiments, it is also possible to use a PN junction diode in place of transistors Q04.

Furthermore, it is also possible to substitute a resistor element formed from, for example, polysilicon or the like for transistor Q01.

By implementing the present invention in the above described manner, it becomes possible to provide an intermediate potential generating circuit which can obtain a stable output potential without depending on power source fluctuation.

As will be readily apparent to those skilled in the art, various modifications can be made to the described embodiments without departing from the scope of the invention.

**Claims**

1. An intermediate potential generating circuit comprising,
 a load element (Q01) of which one end is connected to a first potential supply source ($V_{DD}$);
 a first transistor (Q02) of a first conductivity type of which one end and the gate are connected to the other end of the load element (Q01);
 a second transistor (Q03) of a second conductivity type of which one end is connected to the other end of the first transistor (Q02), and the gate and the other end are connected together;
 a third transistor (Q05) of the first conductivity type of which one end is connected to the first potential supply source ($V_{DD}$), the gate is connected to a node (n1) between the load element (Q01) and the first transistor (Q02), and the other end is connected to an output terminal ($V_{out}$); and
 a fourth transistor (Q06) of the second conductivity type which is connected between the output terminal ($V_{out}$) and a second supply source ($V_{SS}$) and of which the gate is connected to the gate and the said other end of the second transistor (Q03), characterised by
 a constant-voltage means (Q04), connected between the other end of the second transistor (Q03) and the second potential supply source ($V_{SS}$) for causing a specified voltage drop between the ends of the constant voltage means.

2. An intermediate potential generating circuit as claimed in claim 1, furter characterised in that the sum of the threshold voltage of the first transistor (Q02) and the absolute value of the threshold voltage of the second transistor (Q03) is smaller than the sum of the threshold voltage of the third transistor (Q05) and the absolute value of the threshold of the fourth transistor (Q06).

3. An intermediate potential generating circuit as claimed in claim 1 or claim 2, further characterised in that the first transistor (Q02) is provided with a back gate, the back gate being connected to a node (n3) between the first transistor (Q02) and the second transistor (Q03).

4. An intermediate potential generating circuit as claimed in any preceding claim, further characterised in that the second transistor (Q03) is provided with a back gate, the back gate being connected to the node (n3) between the first transistor (Q02) and the second transistor (Q03).

5. An intermediate potential generating circuit as claimed in any preceding claim, further characterised in that the constant-voltage means comprises a fifth transistor (Q04) of the first conductivity type.

6. An intermediate potential generating circuit as claimed in any of claims 1 to 4, further characterised in that the constant-voltage means comprises a diode.

7. An intermediate potential generating circuit as claimed in any preceding claim, further characterised in that the load element comprises a resistor.

8. An intermediate potential generating circuit as claimed in any of claims 1 to 5 or claim 7, further characterised in that the constant voltage means (Q04) comprises a fifth transistor of which the gate is connected to the gate of the fourth transistor (Q06) and the other end of the second transistor (Q03).

## Revendications

1. Un circuit générateur d'une tension intermédiaire comprenant

   un élément de charge (Q01) dont une extrémité est connectée à une première source d'alimentation en tension ($V_{DD}$);

   un premier transistor (Q02) d'un premier type de conductivité, dont une extrémité et la grille sont connectées à l'autre extrémité de l'élément de charge (Q01);

   un deuxième transistor (Q03) d'un deuxième type de conductivité, dont une extrémité est connectée à l'autre extrémité du premier transistor (Q02), la grille et l'autre extrémité étant connectées ensemble;

   un troisième transistor (Q05) du premier type de conductivité, dont une extrémité est connectée à la première source d'alimentation en tension ($V_{DD}$), la grille étant connectée à un noeud (n1) entre l'élément de charge (Q01) et le premier transistor (Q02), l'autre extrémité étant connectée à une borne de sortie ($V_{out}$); et

   un quatrième transistor (Q06) du deuxième type de conductivité, connecté entre la borne de sortie ($V_{out}$) et une deuxième source d'alimentation ($V_{SS}$), et dont la grille est connectée à la grille de ladite autre extrémité du deuxième transistor (Q03), caractérisé par

   un moyen de tension continue (Q04) connecté entre l'autre extrémité du deuxième transistor (Q03) et la deuxième source d'alimentation en tension ($V_{SS}$) pour entraîner une chute de tension spécifiée entre les extrémités du moyen de tension continue.

2. Un circuit générateur d'une tension intermédiaire selon la revendication 1, caractérisé en outre en ce que la somme de la tension de seuil du premier transistor (Q02) et de la valeur absolue de la tension de seuil du deuxième transistor (Q03) est plus petite que la somme de la tension de seuil du troisième transistor (Q05) et de la valeur absolue de la tension de seuil du quatrième transistor (Q06).

3. Un circuit générateur d'une tension intermédiaire selon la revendication 1 ou la revendication 2, caractérisé en outre en ce que le premier transistor (Q02) comporte une grille arrière, la grille arrière étant connectée à un noeud (n3) entre le premier transistor (Q02) et le deuxième transistor (Q03).

4. Un circuit générateur d'une tension intermédiaire selon l'une quelconque des revendications précédentes, caractérisé en outre en ce que le deuxième transistor (Q03) comporte une grille arrière, la grille arrière étant connectée au noeud (n3) entre le premier transistor (Q02) et le deuxième transistor (Q03).

5. Un circuit générateur d'une tension intermédiaire selon l'une quelconque des revendications précédentes, caractérisé en outre en ce que le moyen de tension continue comprend un cinquième transistor (Q04) du premier type de conductivité.

6. Un circuit générateur d'une tension intermédiaire selon l'une quelconque des revendications 1 à 4, caractérisé en outre en ce que le moyen de tension continue comprend une diode.

7. Un circuit générateur d'une tension intermédiaire selon l'une quelconque des revendications précédentes, caractérisé en outre en ce que l'élément de charge comprend une résistance.

8. Un circuit générateur d'une tension intermédiaire selon l'une quelconque des revendications 1 à 5 ou selon la revendication 7, caractérisé en outre en ce que le moyen de tension continue (Q04) comprend un cinquième transistor dont la grille est connectée à la grille du quatrième transistor (Q06) et à l'autre extrémité du deuxième transistor (Q03).

## Patentansprüche

1. Schaltung zur Erzeugung einer Zwischenspannung, umfassend:

ein Lastglied (Q01), dessen einer Anschluß an eine erste Spannungsversorgungsquelle (V$_{DD}$) angeschlossen ist;

einen ersten Transistor (Q02) eines ersten Leitfähigkeitstyps, dessen einer Anschluß und dessen Gate an den anderen Anschluß des Lastgliedes (Q01) angeschlossen ist;

einen zweiten Transistor (Q03) eines zweiten Leitfähigkeitstyps, dessen einer Anschluß an den anderen Anschluß des ersten Transistors (Q02) angeschlossen ist, und dessen Gate und der andere Anschluß zusammengeschaltet sind;

einen dritten Transistor (Q05) vom ersten Leitfähigkeitstyp, dessen einer Anschluß an die erste Spannungsversorgungsquelle (V$_{DD}$) angeschlossen ist und dessen Gate an einen Verbindungspunkt (n1) zwischen dem Lastglied (Q01) und dem ersten Transistor (Q02) angeschlossen ist, und dessen anderer Anschluß an einen Ausgangsanschluß (V$_{out}$) angeschlossen ist; und

einen vierten Transistor (Q06) des zweiten Leitfähigkeitstyps, der zwischen dem Ausgangsanschluß (V$_{out}$) und einer zweiten Spannungsversorgungquelle (V$_{SS}$) angeschlossen ist, und dessen Gate an das Gate und den anderen Anschluß des zweiten Transistors (Q03) angeschlossen ist,

**gekennzeichnet** durch

eine Konstantspannungseinrichtung (Q04), die zwischen dem anderen Anschluß des zweiten Transistors (Q03) und der zweiten Spannungsversorgungsquelle (V$_{SS}$) angeschlossen ist, um einen vorgegebenen Spannungsabfall zwischen den Anschlüssen der Konstantspannungseinrichtung zu erzeugen.

2. Schaltung zur Erzeugung einer Zwischenspannung nach Anspruch 1, weiter dadurch **gekennzeichnet,** daß die Summe aus der Schwellwertspannung des ersten Transistors (Q02) und dem absoluten Wert der Schwellwertspannung des zweiten Transistors (Q03) kleiner ist als die Summe aus der Schwellwertspannung des dritten Transistors (Q05) und dem absoluten Wert des Schwellwerts des vierten Transistors (Q06).

3. Schaltung zur Erzeugung einer Zwischenspannung nach Anspruch 1 oder 2, weiter dadurch **gekennzeichnet,** daß der erste Transistor (Q02) mit einem Rückgate versehen ist, wobei das Rückgate an einen Verbindungspunkt (n3) zwischen dem ersten Transistor (Q02) und dem zweiten Transistor (Q03) angeschlossen ist.

4. Schaltung zur Erzeugung einer Zwischenspannung nach einem der vorhergehenden Ansprüche, weiter dadurch **gekennzeichnet,** daß der zweite Transistor (Q03) mit einem Rückgate versehen ist, wobei das Rückgate an einen Verbindungspunkt (n3) zwischen dem ersten Transistor (Q02) und dem zweiten Transistor (Q03) angeschlossen ist.

5. Schaltung zur Erzeugung einer Zwischenspannung nach einem der vorhergehenden Ansprüche, weiter dadurch **gekennzeichnet,** daß die Konstantspannungseinrichtung einen fünften Transistor (Q04) des ersten Leitfähigkeitstyps enthält.

6. Schaltung zur Erzeugung einer Zwischenspannung nach einem der Ansprüche 1 bis 4, weiter dadurch **gekennzeichnet,** daß die Konstantspannungseinrichtung eine Diode enthält.

7. Schaltung zur Erzeugung einer Zwischenspannung nach einem der vorhergehenden Ansprüche, weiter dadurch **gekennzeichnet,** daß das Lastglied einen Widerstand enthält.

8. Schaltung zur Erzeugung einer Zwischenspannung nach einem der Ansprüche 1 bis 5 oder Anspruch 7, weiter dadurch **gekennzeichnet,** daß die Konstantspannungseinrichtung (Q04) einen fünften Transistor enthält, dessen Gate an das Gate des vierten Transistors (Q06) und an den anderern Anschluß des zweiten Transistors (Q03) angeschlossen ist.

Fig. 1
PRIOR ART

Fig. 2
PRIOR ART

7

Fig. 3
PRIOR ART

Fig. 4

Fig. 5

Fig. 6

Fig. 7